# EUROPÄISCHE PATENTSCHRIFT

(11) **EP 2 773 794 B1**
(45) Veröffentlichungstag und Bekanntmachung des Hinweises auf die Patenterteilung: **09.09.2015**
(21) Anmeldenummer: 12778083.1
(22) Anmeldetag: 17.10.2012
(51) Int. Cl.: C23C 22/02, C09D 5/02, C09D 183/14, C23C 14/12

(54) **BEHANDLUNG VON STAHLOBERFLÄCHEN**
TREATMENT OF STEEL SURFACES
TRAITEMENT DE SURFACES EN ACIER

(30) Priorität: 02.11.2011 DE 102011085574
(43) Veröffentlichungstag der Anmeldung: 10.09.2014
(73) Patentinhaber: Wacker Chemie AG, 81737 München (DE)
(72) Erfinder: FABRY, Laszlo, 84489 Burghausen (DE); MÜLLER, Barbara, 84508 Burgkirchen (DE); STEPP, Michael, A-5122 Überackern (AT)
(74) Vertreter: Killinger, Andreas
(86) Internationale Anmeldenummer: PCT/EP2012/070543
(87) Internationale Veröffentlichungsnummer: WO 2013/064372

(56) Entgegenhaltungen:
- EP-A1- 1 850 413
- EP-A2- 1 308 428
- US-A- 3 085 908
- US-A1- 2003 157 391
- US-A1- 2006 088 666
- US-A1- 2008 312 356

## Beschreibung

Gegenstand der Erfindung ist ein Verfahren zur Behandlung einer Stahloberfläche.

Durch eine solche Behandlung soll eine Passivierung der korrosionsfähigen Oberflächen von Stahlbehältnissen, chemischen Reaktoren, Rohrleitungen, Destillationskolonnen, Stahlträger usw. bewerkstelligt werden. Insbesondere bezieht sich die Erfindung auf die Passivierung von Oberflächen in chemischen Anlagen oder Anlagenteilen, die gleichzeitig mit Restfeuchtigkeit, Chlor, Chlorwasserstoff [P.M. Bhadha, E. R. Greece: Joule-Thomson Expansion and Corrosion in HCl Systems in Solid State Technology July 1992 pp.S3-S7] Chlorsilanen, Wasserstoff und reaktivem elementarem Silicium in Berührung kommen.

Es ist bekannt, dass Restfeuchtigkeit in Gasen und/oder Edelstahlanlagen in Anwesenheit von Chlorwasserstoff Korrosion verursacht [J. Y. P. Mui: Corrosion Mechanism of Metals and Alloys in the Silicon-Hydrogen-Chlorosilane System at 500 C in Corrosion - NACE, 41(2), 1985 pp. 63-69; W. C. Breneman: Direct Synthesis of Chlorosilanes and Silane in Catalyzed Direct Reactions of Silicon, Elsevier 1993 pp. 441-457, insbes. Tab 3 on p. 454].

In der reduktiven Atmosphäre eines Chlorsilan-Chlorwasserstoff-Wasserstoff-Gemisches kann ein natürlicher Korrosionsschutz an der Oberfläche von Kohlenstoffstahl oder von Edelstahl bei über 500°C enstehen. Das trifft auch auf SiC-beschichteten Kohlenstoffstahl zu.

Bei Edelstahl-Behältnissen wird der Stahl üblicherweise auf Chlorid-Spannungskorrosion gestestet.

Chlorwasserstoff chloriert Phosphor-haltige Bestandteile der Stahllegierung [H. Viefhaus, B. Richarz: Phosphor in Eisen und Stahl in Materials and Corrosion, 46, 1995 pp. 306-316], wodurch sich Phosphorchloride bilden, die entweder als flüchtige Kontamination den Silanstrom belasten oder mit Silanen bzw. Borverbindungen undefinierte Addukte bilden können, die in der destillativen Aufreinigung von Chlorsilanen von den Produkten nicht abgetrennt werden können [Xiao Ji-mei, Shen Hua-sheng: The Theoretical Aspects of Preventing Corrosion of Stainless Steel ... in the Production of Polycrystalline Silicon in Xiyou-jinshu - Rare Metals, Chin. Vol 1-2, 1982 pp. 3-15, insbes. Gleichung (44) und pp. 13-15].

In der reduktiven Wasserstoff-Atmosphäre einer Abscheidung von polykristallinem Silicium (Siemens-Prozess US7708970 B2; Chlorsilan und Wasserstoff als Edukte) werden Phosphorchloride reduziert und Phosphor bevorzugt in das abgeschiedene polykristalline Silicium eingebaut.

Passivierung der Stahloberfläche kann die Feuchte wie die reduktive Korrosion verlangsamen bzw. verhindern.

Aus JP7090288 A2 und US 2985677 A ist bekannt, dass siliciumorganische Halogenverbindungen an Stahloberflächen chemisorptiv als Silylester an aktiven Fe-OH Zentren gebunden werden, sodass sie als ölfreies Schmiermittel bei der Bearbeitung von Stahlblechen verwendbar sind.

JP8010703 A2 offenbart Polysiloxane aus der Hydrolyse und der Kondensation von organischen Chlorsilanen als Grundierung für Korrosionsschutzbestandteil sowie als Korrosionsschutzharze.

In DE 3920297 A1 werden Heteropolykondensate von Siloxy-Aluminatestern mit hydrolysierbare Reste tragenden Organosilanen ggf. unter Zusatz von organofunktionellen Silanen mit Kieselsäurerestern als Korrosionsschutz beschrieben. Der Korrosionsschutz wird dabei durch Eintauchen in ein Silanisierungsbad und anschließende Trocknung bewerkstelligt.

Die Trocknung erfolgt bei mindestens 50°C.

US 2003/157391 A1 offenbart die Verwendung von einem alpha-aminofunktionellen Alkoxysilan bzw. von N-(2-aminoethyl)-3-aminopropyltrimethoxysilan zur Behandlung von Edelstahloberflächen.

US 2008/312356 A1 offenbart ein Verfahren zur Behandlung von Edelstahloberflächen mittels Bedampfen mit aminofunktionellen Silanen bei einer Temperatur von 20°C bis 100°C.

Die Aufgabe der vorliegenden Erfindung bestand darin, eine homogene Passivierung ohne Eintauchen oder Sprühen und ohne Nachbehandlung aus der Dampf-/Gasphase zu erreichen. Außerdem sollte die Passivierung bei einer Oberflächentemperatur von 50°C oder weniger erfolgen.

Diese Aufgabe wird durch die Erfindung gelöst.

Die Erfinder haben durch umfangreiche Untersuchungen eine Gruppe von funktionellen Silanen gefunden, die auch bei niedrigeren Temperaturen mit aktiven Stahloberflächen reagieren können.

Die Erfindung betrifft die Verwendung von alpha-aminofunktionellen Alkoxysilanen zur Behandlung von phosphorhaltigen Stahloberflächen, die nachfolgend einer korrosiven Atmosphäre eines Gasgemisches aus Restfeuchtigkeit, Chlor, Chlorwasserstoff, Chlorsilanen, Wasserstoff und ggf. reaktivem elementarem Silicium ausgesetzt werden.

Die Erfindung sieht eine korrosionshemmende Oberflächenbehandlung phosphorhaltiger Stahloberflächen vor, die einfacher und schonender durchgeführt werden kann, als nach dem bekannten Stand der Technik, insbesondere kann die Behandlung an eingebauten Stahlgegenständen mit Hinterschneidungen (Rohrleitungen, Behälter, Apparate etc.) erfolgen, bei denen ein Tauch- oder Sprühvorgang nur mit großem Aufwand durchführbar wäre.

Außerdem werden deutlich geringere Mengen für die Oberflächenbehandlung benötigt als z.B. beim Tauch- oder Flutungsverfahren, was die Wirtschaftlichkeit erhöht und die Umweltbelastung vermindert.

Dabei wird die zu behandelnde Stahloberfläche bei einer Oberflächentemperatur von weniger als 50°C mit alpha-aminofunktionellen Alkoxysilanen bedampft.

Vorzugsweise ist ein unter den Anwendungsbedingungen inertes Lösungsmittel anwesend (ausgewählt aus Alkoholen (Methanol, Ethanol, Isopropanol, Ethern (Dimethylether, Diethylether, Diisopropylether, Dioxan, Tetrahydrofuran), Ketonen (Aceton, Methyethylketon [MEK]), linearen oder verzweigten Alkanen (n-Butan, n-Pentan, n-Hexan, n-Heptan) oder Alkangemischen (Petrolether mit einem Siedebereich zwischen 40 und 60°C), halogenierte Alkane (Chlormethan, Dichlormethan, Trichlormethan, Tetrachlormethan, Chlorethan), Aromaten (Benzol, Toluol, o-Xylol, Pyridin), ggf. substituiert wie Methoxybenol, Chlorbenzol oder Hexamethyldisiloxan.).

Vorzugsweise wird ein Lösungsmittel mit einem Siedepunkt beim Druck der umgebenden Atmosphäre von weniger als 150°C, besonders bevorzugt weniger als 100°C, ganz besonders bevorzugt weniger als 70°C, verwendet.

Bei den Alkoxysilanen handelt es sich vorzugweise um N,N-(Diethylaminomethyl)dimethoxymethylsilan oder um eine Mischung von (2-Aminoethyl)aminomethyltrimethoxy-silan und dessen Azacyklus handelt.

Vorgehensweise der Oberflächenbehandlung: der für die Behandlung benötigte Dampf wird beispielsweise entweder durch Verdampfen des Silans (oder Gemischs ggf. in Anwesenheit eines Lösungsmittels) durch Erwärmen in einer Apparatur (Verdampfer) oder mittels Durchleiten eines ggf. erwärmten Gases (N2, He, Ar, Luft) durch das flüssige, ggf. erwärmte Silan (oder Gemisch ggf. in Anwesenheit eines Lösungsmittels) (Sättiger) erzeugt und an die zu behandelnde Oberfläche geleitet.

Dies geschieht entweder über Rohrleitungen oder direkt an die Apparatur angeschlossene Apparaturen oder innerhalb der Apparatur, oder der zu behandelnde Gegenstand wird in einer Kammer platziert, die mit dem Dampf beaufschlagt wird.

Um Kondensation des Dampfes und damit Abreicherung in Nähe der Eintrittsstelle zu vermeiden, kann es insbesondere bei der Behandlung von Innenräumen von Apparaten mit großem Längen/Durchmesser-Verhältnis sinnvoll sein, die Oberflächen vor und während des Behandlungsprozesses zu erwärmen.

Es können auch Aerosole eingesetzt werden für die Gleiches gilt. Sie lassen sich z.B. durch Ultraschallgeber leicht erzeugen und mittels eines Gasstromes an die Oberfläche leiten.

Auch eine Behandlung mit Mischungen aus Aerosol und Dampf ist denkbar.

Die Behandlungsdauer richtet sich nach der verdampfbaren Menge Silan und der Größe der zu behandelnden Oberfläche.

Der Behandlungsprozess lässt sich leicht durch Detektion des aus der Apparatur austretenden Dampf/Aerosol/Gasstromes verfolgen.

Beispielsweise lassen sich mit Hilfe von feuchtem Indikatorpapier saure und basische Silane nachweisen.

Überschüssiges Silan kann an der Auslassöffnung mit Hilfe eines Kondensators einfach auskondensiert und damit zurückgewonnen werden.

Diese Vorgehensweise ermöglicht eine Kreislauffahrweise, bei der die Menge des auf die Oberfläche aufgebrachten Silans durch einfaches Rückwägen ermittelt werden kann und gewährleistet außerdem, die Umweltbelastung möglichst gering zu halten.

Überschüssiges Silan kann jedoch auch mittels Wäscher oder Adsorber abgefangen werden.

Erfahrungsgemäß sind Siloxanbeschichtungen bis etwa 300°C thermisch stabil, siehe z.B. W. Noll: Chemie und Technologie der Silicone, Verlag Chemie, Weinheim'1960, Seite 151. Damit läßt sich Korrosion auch bei 200°C verlangsamen.

Die Erfindung ermöglicht somit eine zumindest temporärpassivierend wirkende Beschichtung korrosionsempfindlicher Stahloberflächen nach einer Oberflächenbehandlung bei Temperaturen von kleiner als 50°C gegenüber der korrosiven Atmosphäre eines Gasgemisches aus Restfeuchtigkeit, Chlor, Chlorwasserstoff, Chlorsilanen, Wasserstoff und ggf. reaktivem elementarem Silicium.

Durch die Passivierung wird die Phosphor-Extraktionsrate, d.h. auch der Phosphorgehalt des in der Stahlanlage abgeschiedenen polykristallinen Siliciums reduziert, so dass sich die Inbetriebnahme entsprechender Anlagen ohne Qualitätsgefährdung beschleunigen läßt. Insbesondere in geschlossenen Systemen zur Abscheidung von Polysilicium mit Chlorsilanen die in Verbindung mit Feuchte auf Stahloberflächen Korrosionseffekte bewirken, zeigt der Einsatz große Vorteile z.B. in Wasserstoffkreisgas oder in Chlorsilankondensationssystemen.

### Beispiele

Es wurde eine umfangreiche Versuchsreihe mit unterschiedlichen Silanen bzw. deren Derivaten durchgeführt.

Anschließend wurden beschichtete und nicht beschichtete Stahlproben einer korrosiven Atmosphäre aus feuchtem Chlorwasserstoff (Salzsäure) ausgesetzt.

Die Stahlproben wurden vor der Behandlung mit der entsprechenden Verbindung mit VE-Wasser abgereinigt und mit Aceton getrocknet. Zwischen den einzelnen Behandlungsschritten wurden die Stahlproben zum Schutz vor Umwelteinflüssen insbesondere Luftfeuchte in inerter Atmosphäre in einem Exsikkator gelagert. Vor Beginn des ersten Behandlungsschritts wurden die Stahlproben gewogen, ebenso nach jedem der einzelnen Behandlungsschritte. Abschließend wurde der durch Korrosion bedingte Gewichtsverlust an den Probenkörpern bestimmt. Die Dokumentation des Zustands der Probenkörper in Abhängigkeit von den gewählten Versuchsbedingungen (Silan, Material, Behandlungsdauer etc.) erfolgte über Fotos, per Lichtmikroskopie und über REM.

Die einzelnen Behandlungsschritte nach der erfolgten Reinigung und Dokumentation des Ausgangszustands sind im Folgenden dargestellt.

Die Probenkörper wurden in einen Exsikkator verbracht und über dem entsprechenden Silan bei einer Umgebungstemperatur von 40°C gelagert.

Die mit Silan vorbehandelten Stahlproben sowie jeweils eine Vergleichsprobe wurden a) für 48 h oder b) für 4 h über konzentrierter Salzsäure bei jeweils 40°C gelagert. Mit diesem Behandlungsschritt können korrosive Bedingungen wie sie auch in den eingangs beschriebenen Stahlkörpern vorherrschen simuliert werden.

Die Proben wurden nach jedem Behandlungsschritt mit optischenmikroskopischen und mit elektronmikroskopischen Verfahren untersucht und mit EDX (energy dispersive X-ray) analysiert sowie beurteilt.

An den Schliffbildern der Proben sind unterschiedliche korrosive Abträge in Abhängigkeit .vom verwendeten Silan und der Behandlungsdauer beurteilt worden.

Es kamen unterschiedlich vorbehandelte Stahlproben zweier Materialarten zum Einsatz: Austenitische Chrom-Nickel-Edelstahl und Kohlenstoffstahl-Legierungen.

Die Proben wurden vorbehandelt: entweder nur gebeizt, oder gebeizt und geschliffen.

Zum Beizen der Werkstoffe wurden folgende Beizlösungen verwendet:
20 Volumenteile Salzsäure (1,18 g/cm³ = 37 Masse-%),
3 Volumenteile Salpetersäure (1,39 g/cm³ = 65 Masse-%),
77 Volumenteile Wasser.

Die Badtemperatur überschritt nicht 50°C. Der Materialabtrag war ≤ 3 µm.

Nach dem Beizen wurden die Teile mit Trinkwasser (Chlor-Ionen-Gehalt ≤ 50 ppm) so lange gespült, bis an den gebeizten Teilen keine Säure mehr festgestellt werden konnte. Die Neutralität wurde mit Indikatorpapier nachgewiesen.

Zum Schleifen wurden gewöhnliche Schleifscheiben oder Rotorfächer-Schleifer benutzt.

Die zu wählende Korngröße wurde stufenweise und in geeigneter Form der Körnung des Endschliffes und dem Reinigungseffekt angepasst.

Die Oberflächenbehandlung wurde mit einer gemittelten Rautiefe von Rz ≤ 4 µm ausgeführt.

Diese Rautiefe kann in der Regel beim Schleifen mit einer Körnung von 240 oder feiner erzielt werden.

Bei den Referenz-Proben wurde keine Behandlung mit einem Silan oder mit einem Azacyklus vorgenommen.

Bei den anderen Proben kamen folgende Silane zum Einsatz: Diethylamino-methyltrimethoxysilan, H-Triethoxysilan, TM 10/47-2 (Umsetzungsprodukt aus Si(OEt)4 und SiCl4 (nach GC: 52% ClSi(OEt)3, 12% Cl2Si(OEt)2), 35% Cl3Si(OEt)), N,N-Diethylaminomethyl)dimethoxymethylsilan (97,8 GC-%) und (2-Aminoethyl)aminomethyltrimethoxy-silan (93,3 GC-%) und der entsprechende Azacyklus (4,5 GC-%) - GC=Gas Chromatograph.

**Tabelle 1** zeigt die Strukturen der untersuchten Silane.

**Tabelle 1**

| **Verbindung** | **Struktur** |
|---|---|
| Diethylamino-methyltrimethoxysilan | Et2N-CH2-Si(OMe)3 |
| H-Triethoxysilan | HSi(OEt)3 |
| TM 10/47-2 | Umsetzungsprodukt aus Si(OEt)4 und SiCl4 (nach GC: 52% ClSi (OEt) 3, 12% Cl2Si(OEt)2), 35% Cl3Si(OEt) |
| (N,N-Diethylaminomethyl)dimethox ymethylsilan (97,8 GC-%) | 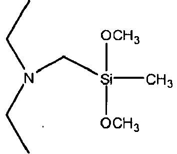 |
| (2-Aminoethyl)aminomethyltrime thoxysilan 93,3 GC-%) und der entsprechende Azacyclus (4,5 GC-%) | 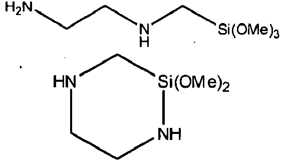 |

Die Strukturen wurden jeweils durch ¹H- und ²⁹Si-NMR bestätigt.

Als Vergleichsprobe wurde jeweils die vorbehandelte, aber nicht mit einem Silan konditionierte Stahlprobe aus dem entsprechenden Material eingesetzt.

Die Stahlproben wurden vor der Behandlung mit der entsprechenden Verbindung mit vollentsalztem (VE)-Wasser abgereinigt, mit Aceton abgespült und getrocknet.

Zwischen den einzelnen Behandlungsschritten wurden die Stahlproben zum Schutz vor Umwelteinflüssen insbesondere Luftfeuchte in inerter z. B. Stickstoffatmosphäre in einem Exsikkator gelagert.

Vor Beginn des ersten Behandlungsschritts wurden die Stahlproben gewogen, ebenso nach jedem der einzelnen Behandlungsschritte.

Abschließend wurde der durch Korrosion bedingte Gewichtsverlust an den Probenkörpern bestimmt.

Die Dokumentation des Zustands der Probenkörper in Abhängigkeit von den gewählten Versuchsbedingungen (Silan, Material, Behandlungsdauer etc.) erfolge über Fotos, per Lichtmikroskopie bzw. über REM.

Die einzelnen Behandlungsschritte nach der erfolgten Reinigung und Dokumentation des Ausgangszustands sind im Folgenden dargestellt.
- Die Probenkörper wurden in einen Trockner (Exsikkator) verbracht und über dem entsprechenden Silan bei einer Umgebungstemperatur von 40°C für 48 h gelagert.
- Die mit Silan vorbehandelten Stahlproben sowie jeweils eine Vergleichsprobe wurden a) für 48 h oder b) für 4 h über Salzsäure (36 Massen-%) bei jeweils 40°C gelagert.

Mit diesem Behandlungsschritt können korrosive Bedingungen wie sie auch in den eingangs beschriebenen Rohrleitungen vorherrschen simuliert werden.

**Tabelle 2 und 3** zeigen die Ergebnisse.

**Tabelle 2: Behandlung bei 40°C für 24 h.**

| Nr | Material | Vorbehandlung | Behandlung mit Silan | | | | | | Behandlung mit HCl | | Ergebnis | | |
|---|---|---|---|---|---|---|---|---|---|---|---|---|---|
| | | A, B | U | S1 | S2 | S3 | S4 | S5 | 40°C 24h | 40°C 4h | G | O | B |
| 1 | M1 | A | x | | | | | | x | | 2.3 | | 3 |
| 2 | M1 | A + B | x | | | | | | x | | 2.0 | | 3 |
| 5 | M2 | A | x | | | | | | x | | 1.2 | | 3 |
| 6 | M2 | A + B | x | | | | | | x | | 1.7 | | 3 |
| 9 | M1 | A | | x | | | | | x | | 1.3 | | 3 |
| 10 | M1 | A | | | x | | | | x | | 2.4 | | 3 |
| 11 | M1 | A | | | | x | | | x | | 1.7 | | 3 |
| 14 | M1 | A + B | | x | | | | | x | | 2.1 | | 3 |
| 15 | M1 | A + B | | | x | | | | x | | 3.6 | | 3 |
| 16 | M1 | A + B | | | | x | | | x | | 3.8 | | 3 |
| 19 | M2 | A | | x | | | | | x | | 1.8 | | 3 |
| 20 | M2 | A | | | x | | | | x | | 1.9 | | 3 |
| 21 | M2 | A | | | | x | | | x | | 2.8 | | 3 |
| 24 | M2 | A + B | | x | | | | | x | | 1.7 | | 3 |
| 25 | M2 | A + B | | | x | | | | x | | 1.8 | | 3 |
| 26 | M2 | A + B | | | | x | | | x | | 2.8 | | 3 |

**Tabelle 3: Behandlung bei 40°C für 4 h.**

| Nr | Material | Vorbehandlung | Behandlung mit Silan | | | | | | Behandlung mit HCl | | Ergebnis | | |
|---|---|---|---|---|---|---|---|---|---|---|---|---|---|
| | | A, B | U | S1 | S2 | S3 | S4 | S5 | 40°C 24h | 40 °C 4h | G | O | B |
| 3 | M1 | A | x | | | | | | | x | 3.0 | x | 2 |
| 4 | M1 | A + B | x | | | | | | | x | 4.4 | x | 3 |
| 7 | M2 | A | x | | | | | | | x | 3.7 | x | 2 |
| 8 | M2 | A + B | x | | | | | | | x | 4.9 | x | 3 |
| **12** | **M1** | **A** | | | | | **x** | | | **x** | **2.8** | **x** | **1** |
| **13** | **M1** | **A** | | | | | | **x** | | **x** | **2.9** | **x** | **1** |
| **17** | **Ml** | **A + B** | | | | | **x** | | | **x** | **2.6** | **x** | **1** |
| **18** | **Ml** | **A + B** | | | | | | **x** | | **x** | **3.4** | **x** | **1** |
| **22** | **M2** | **A** | | | | | **x** | | | **x** | **2.8** | **x** | **1** |
| **23** | **M2** | **A** | | | | | | **x** | | **x** | **2.6** | **x** | **1** |
| **27** | **M2** | **A + B** | | | | | **x** | | | **x** | **2.9** | **x** | **1** |
| **28** | **M2** | **A + B** | | | | | | **x** | | **x** | **2.7** | **x** | **1** |

### Legende zu Tabelle 2 und 3

### Materialien

- M1: Chrom-Nickel-Edelstahl
- M2: Kohlenstoffstahl

### Vorbehandlung

- A: gebeizt
- B: geschliffen

### Behandlung mit Silan

- U: unbehandelte Referenzproben
- S1: Diethylamino-methyltrimethoxysilan
- S2: H-Triethoxysilan
- S3: TM 10/47-2
- S4: N,N-(Diethylaminomethyl)dimethoxymethylsilan (97,8 GC-%)
- S5: (2-Aminoethyl)aminomethyltrimethoxy-silan (93,3 GC-%) und der entsprechende Azacyklus (4,5 GC-%)

### Ergebnisse

- G: Gewichtsverlust [mg/h] nach Behandlung mit HCl
- O: optische Untersuchung [Lichtmikroskopie, REM (energy dispersive X-ray)]

Beispiel für optische Untersuchung: Vergrößerungsstufen 3,2 fach (Lichtmikroskop Auflicht Koaxialbeleuchtung) bis 500 fach und EDX-Analyse.

Ab 50 facher Vergrößerung wurde ein Rasterelektronenmikroskop eingesetzt.
- B: Bewertung
- 1: leichte Korrosion = Nicht detektierbare Schleifspuren
- 2: Korrosion = Detektierbare Schleifspuren
- 3: starke Korrosion

Bewertung erfolgte bzgl. abgeätzter, nicht detektierbarer Schleifspuren, detektierbarer Kratzer, Löcher etc.

Die qualitative Beurteilung erfolgte mittels REM. Die quantitative Bewertung über den Gewichtsverlust.

Die Ergebnisse zeigen, dass nach einem erfindungsgemäßen Verfahren die mit Silan- und Azacyklus-Dämpfen bei 40 °C behandelten Stahlträgerkörper sich durch deutlich bessere Korrosionsbeständigkeit gegenüber unbehandelten Trägerkörpern auszeichnen.

Zudem konnte gezeigt werden, dass ein gleichmäßiges Aufbringen der Silanschutzschicht gegeben ist.

Bemerkenswerterweise konnte die Korrosion unter den verfahrensgemäßen Bedingungen gegenüber den unbehandelten. Proben deutlich reduziert werden.

Dies spiegelt sich nicht nur in der verringerten Gewichtsabnahme (gravimetrische Bestimmung), sondern auch in der optischen Untersuchung der behandelten und korrosiven Bedingungen ausgesetzten Probenkörpern wieder.

Typische Schliff-Strukturen, die auch nach dem korrosiven Behandlungsschritt bei den mit (2-Aminoethyl)aminomethyltrimethoxysilan (93,3 GC-%) und der entsprechende Azacyklus (4,5 GC-%) behandelten weitgehend erhalten bleiben, stützen und verdeutlichen den gravimetrischen Befund.

### Vergleichsbeispiel

Eine neu montierte Rohrleitung Länge 87 m, Durchmesser 250 mm aus Kohlenstoffstahl wurde ohne Oberflächenbehandlung nach einer eintägigen Stickstoffspülung mit 10000 m³/h eingesetzt.

Diese Stahlrohrleitung wurde mit 9980 Nm³/h Wasserstoff beschickt bzw. im Kreis gefahren.

Die Fremdgasanteile wurden als HCl 0,8 vol% und Feuchtigkeit 0,14 ppmv bestimmt.

Aus diesem Wasserstoffstrom wurde 1930 Nm³/h in bzw. durch einen laufenden Siemens-Reaktor zur Polysiliciumabscheidung aus Trichlorsilan geleitet.

In den ersten abgeschiedenen Polysiliciumstäben wurde ein Phosphorgehalt von 400 ppta gemessen.

Die Phosphorkontamination der Polysiliciumstäbe konnte den spezifizierten Wert von kleiner als 40 ppta erst nach 30 Tagen, nach der achten Charge erreichen.

### Beispiel

Eine neu montierte Stahlrohrleitung Länge 89 m, Durchmesser 250 mm aus Kohlenstoffstahl wurde mit 10000 Nm³/h durch(2-Aminoethyl)aminomethyltrimethoxysilan (93,3 GC-%)gesättigtem Stickstoff 24 Stunden bei 25-28°C gespült.

Nach dieser Behandlung wurde die Rohrleitung mit 10000 Nm³/h Wasserstoff beschickt bzw. im Kreis gefahren.

Die Fremdgasanteile wurden als HCl 0,9 vol% und Feuchtigkeit 0,14 ppmv bestimmt.

Aus diesem Wasserstoffstrom wurde 1940 Nm³/h in bzw. durch einen laufenden Siemens-Reaktor zur Polysiliciumabscheidung aus Trichlorsilan geleitet.

In den ersten abgeschiedenen Polysiliciumstäben wurde ein Phosphorgehalt von 100 ppta gemessen und schon die zweite Charge erreichte den spezifizierten Wert von 40 ppta.

## Patentansprüche

1. Verwendung von alpha-aminofunktionellen Alkoxysilanen zur Behandlung von phosphorhaltigen Stahloberflächen, die nachfolgend einer korrosiven Atmosphäre eines Gasgemisches aus Restfeuchtigkeit, Chlor, Chlorwasserstoff, Chlorsilanen, Wasserstoff und ggf. reaktivem elementarem Silicium ausgesetzt werden.

2. Verwendung nach Anspruch 1, wobei es sich bei den Alkoxysilanen um N,N-(Diethylaminomethyl)dimethoxymethylsilan oder um eine Mischung von (2-Aminoethyl)aminomethyltrimethoxysilan und dessen Azacyklus handelt.

3. Verfahren zur Behandlung einer phosphorhaltigen Stahloberfläche mittels Bedampfen der Stahloberfläche mit alpha-aminofunktionellen Alkoxysilanen, wobei die Behandlung bei einer Temperatur der Stahloberfläche von weniger als 50°C erfolgt und die bedampfte Stahloberfläche nachfolgend einer korrosiven Atmosphäre eines Gasgemisches aus Restfeuchtigkeit, Chlor, Chlorwasserstoff, Chlorsilanen, Wasserstoff und ggf. reaktivem elementarem Silicium ausgesetzt wird.

4. Verfahren nach Anspruch 3, wobei es sich bei den Alkoxysilanen um N,N-(Diethylaminomethyl)dimethoxymethylsilan oder um eine Mischung von (2-Aminoethyl)aminomethyltrimethoxysilan und dessen Azacyklus handelt.

5. Verfahren nach Anspruch 3, wobei während der Behandlung ein Aerosol auf die Stahloberfläche geleitet wird.

## Claims

1. Use of alpha-amino-functional alkoxysilanes for the treatment of phosphorus-containing steel surfaces which are subsequently exposed to a corrosive atmosphere of a gas mixture composed of residual moisture, chlorine, hydrogen chloride, chlorosilanes, hydrogen and possibly reactive elemental silicon.

2. Use according to Claim 1, wherein the alkoxy-silanes are N,N-(diethylaminomethyl)dimethoxymethyl-silane or a mixture of (2-aminoethyl)aminomethyl-trimethoxysilane and the azacycle thereof.

3. Process for the treatment of a phosphorus-containing steel surface by means of treatment of the steel surface with the vapour of alpha-amino-functional alkoxysilanes, wherein the treatment is carried out at a temperature of the steel surface of less than 50°C and the vapour-treated steel surface is subsequently exposed to a corrosive atmosphere of a gas mixture composed of residual moisture, chlorine, hydrogen chloride, chlorosilanes, hydrogen and possibly reactive elemental silicon.

4. Process according to Claim 3, wherein the alkoxy-silanes are N,N-(diethylaminomethyl)dimethoxymethylsilane or a mixture of (2-aminoethyl)aminomethyltrimethoxysilane and the azacycle thereof.

5. Process according to Claim 3, wherein an aerosol is directed onto the steel surface during the treatment.

## Revendications

1. Utilisation d'alcoxysilanes à fonctionnalité amino en position alpha pour le traitement de surfaces d'acier contenant du phosphore, qui sont ensuite soumises à une atmosphère corrosive d'un mélange gazeux constitué d'humidité résiduelle, de chlore, de chlorure d'hydrogène, de chlorosilanes, d'hydrogène et le cas échéant de silicium élémentaire réactif.

2. Utilisation selon la revendication 1, où il s'agit, pour les alcoxysilanes, de N,N-(diéthylaminométhyl)diméthoxyméthylsilane ou d'un mélange de (2-aminoéthyl)aminométhyltriméthoxysilane et de son cycle aza.

3. Procédé pour le traitement d'une surface d'acier contenant du phosphore par vaporisation de la surface d'acier à l'aide d'alcoxysilanes à fonctionnalité amino en position alpha, le traitement ayant lieu à une température de la surface d'acier inférieure à 50°C et la surface d'acier vaporisée étant ensuite soumise à une atmosphère corrosive d'un mélange gazeux constitué d'humidité résiduelle, de chlore, de chlorure d'hydrogène, de chlorosilanes, d'hydrogène et le cas échéant de silicium élémentaire réactif.

4. Procédé selon la revendication 3, où il s'agit, pour les alcoxysilanes, de N,N-(diéthylaminométhyl)diméthoxyméthylsilane ou d'un mélange de (2-aminoéthyl)aminométhyltriméthoxysilane et de son cycle aza.

5. Procédé selon la revendication 3, un aérosol étant guidé sur la surface d'acier pendant le traitement.
